# EUROPEAN PATENT APPLICATION

(11) **EP 4 819 779 A1**
(43) Date of publication of application: **07.10.2026**
(21) Application number: 26168169.6
(22) Date of filing: 26.03.2026
(51) Int. Cl.: H05K 7/14

(54) **BOARD-TO-BOARD STACKING ARRANGEMENT**

(30) Priority: 01.04.2025 US 202519097440
(71) Applicant: Aivres Systems Inc., San Jose, CA 95133 (US)
(72) Inventor: Li, Han-yi, New Taipei City (TW)
(74) Representative: Ostertag & Partner Patentanwälte mbB

(57) **Abstract**

A board-to-board assembly for inclusion in a computer system includes a first board subassembly and a second board subassembly in a parallel or stacked orientation and spaced apart in a stacking direction by first and second spacer supports. The spacer supports include guide flanges that straddle one of the first and second board subassemblies. The board-to-board assembly includes a plurality of board-to-board connectors for aligning the first and/or second board subassembly between the guide flanges. The board-to-board assembly includes a board-to-board clamp associated with the guide flanges to secure the board subassemblies together.

## Description

### TECHNICAL FIELD

This patent application relates to components for computing systems and, in particular, to an arrangement for stacking printed circuit boards in a parallel or mezzanine orientation.

### BACKGROUND

Computer systems are assembled from different electronic components and devices that are communicatively interconnected and housed in a common chassis or enclosure. To interconnect the components for the routing of electronic data signals and electrical power, one or more rigid printed circuit boards (PCBs) can be accommodated in the enclosure defined by the chassis. The printed circuit board may include a planar substrate made of an insulative material such as phenolic resin having electrically conductive traces disposed on the planar surfaces or embedded in the laminated structure of the board. Electronic devices, such as resistors, capacitors, and integrated circuits, can be mounted to the planar surface of the printed circuit board and can be communicatively connected by the conductive traces. The arrangement and cooperative operation of the electronic components are responsible for the computational and processing functionality of the computer system.

The printed circuit boards are typically installed within the chassis in separation or in limited contact with respect to other printed circuit boards. For example, for cooling purposes, the printed circuit boards are typically supported with respect to the chassis panels and other components so that the planar surface and electronic devices thereon are exposed to the empty volume within the enclosure. Cooling fans are typically provided to generate airflow within the chassis and provide further cooling.

To electrically connect with other electronic components, including with other circuit boards, electrical connectors are also often mounted on the printed circuit board which can connect with conductive cables or wires. Sometimes it is desirable to physically connect two printed circuit boards directly together, eliminating wires and improving electronic communication. For example, an expansion card or peripheral card may connect to another printed circuit board, such as the motherboard, using a PCI connector. Direct physical connection between printed circuit boards communicatively links the local communication busses thereon improving the transfer of data signals and electrical power.

To maintain physical separation between the interconnected printed circuit boards for continued cooling and to reduce RF or EMF interference, various orientations and arrangements are available. For example, two printed circuit boards can be oriented orthogonally at right angles and thus perpendicularly intersect each other. Right angled connectors or edge connectors can be used to communicatively interface the orthogonal boards. In another example, two printed circuit boards can be placed in a parallel, spaced apart orientation. Such a board-to-board arrangement may be referred to a stacked or mezzanine arrangement.

### SUMMARY OF THE DISCLOSURE

A board-to-board connector, usable for example as a midplane in a computer system, includes first and second board subassemblies that are oriented in a parallel or stacked arrangement and separated from each other in a stacking direction by first and second spacer supports. A plurality of board-to-board connectors can be located between and establish electronic communication between the first and second board subassemblies. A board-to-board clamp can be included to secure the first and second board subassemblies in the stacked arrangement. The spacer supports, board-to-board connectors, and board-to-board clamp are configured to assist with assembly and increase exposure of the opposed faces of the board subassemblies.

For example, the first and second spacer supports can each have a guide flange that extends from an abutment surface of each spacer support which is intended to make abutting contact with the opposed face of the corresponding board subassembly. The guide flanges are configured to staddle the corresponding board subassembly in a lateral direction orthogonal to the stacking direction. The guide flanges may be shorter than the corresponding support width of the spacer supports, measured in a traverse direction orthogonal to the lateral direction, and the support width may be shorter than the board width in the traverse direction. The relatively shorter widths in the traverse direction between the guide flange, the spacer support, and the board subassemblies reduces obstruction of the opposing faces and the external faces of the board subassemblies.

The board-to-board connectors may have a mating height that is larger than the support height associated with the spacer supports in the stacking direction. The board-to-board connectors will mate and align one of the board subassemblies between the guide flanges before abutting contact is made with the abutment surface of the spacer support. The guide flanges can also guide the clamp components of the board-to-board clamp, which may include a pivoting lever and a structural catch, into position with each other. Actuation of the board-to-board clamp forcibly moves the board subassembly into contact with the abutment surfaces of the spacer supports and may apply leverage for the continued mating of the board-to-board connectors.

In a further aspect, a plurality of board-to-board connectors associated with the first and second board subassemblies and arranged in a complementary alignment pattern to align the second board subassembly laterally between the guide flanges of the first and second spacer supports when mated.

In a further aspect, the first and second spacer supports each has a support height and each of the plurality of board-to-board connectors has a mating height that is larger than the support height.

In a further aspect, each of the plurality of board-to-board connectors comprises a prong pin mountable to one of the first and second board subassemblies and a jack socket mountable to the other of the first and second board subassemblies.

In a further aspect, the first and second spacer supports each has a support width and each of the first and second board subassemblies has a board width that is larger than the support width.

In a further aspect, the first and second spacer supports each has an abutment surface, perpendicular to the stacking direction, on which an opposing face of one of the first and second board subassemblies abuts.

In a further aspect, the guide flange of each of the first and second spacer supports extends perpendicularly from the abutment surface thereof.

In a further aspect, the board-to-board clamp comprises a first lever and a second lever each adapted to engage a structural catch on the guide flange on each of the respective first and second spacer supports.

In a further aspect, each of the first and second levers are pivotally attached to one of the first and second board subassemblies.

In a further aspect, each of the structural catches on the guide flange of each of the first and second lateral supports protrudes in the lateral direction.

In a further aspect, the first and second board subassemblies each comprises a first board frame and a second board frame into which the first printed circuit board and the second printed circuit board are respectively installed.

In another aspect, a method of assembling a board-to-board assembly in a mezzanine or stacked arrangement includes positioning first and second board subassemblies in parallel with one another and spaced apart with respect to a stacking direction. The first and second board subassemblies can be associated with a plurality of mating board-to-board connectors in a complementary alignment pattern that are mated by moving the first and second board subassemblies together in the stacking direction. Mating of the board-to-board connectors aligns the first and second board subassemblies between a pair of guide flanges extending from the spacer supports and positions the components of a board-to-board clamp to engage each other. Actuating the board-to-board clamp forcibly moves the first and second board subassemblies relative to each other in the stacking direction against abutment surfaces on the spacer supports and secures the board-to-board assembly. Either of the first or second board subassemblies may be fixedly attached beforehand to the computer system such that the board-to-board assembly becomes spatially fixed and situated in the computer system.

In a further aspect, each of the first and second spacer supports has a support height in the stacking direction and each of the plurality of board-to-board connectors has a mating height that is larger than the support height.

In a further aspect, each of the plurality of board-to-board connectors comprises a prong pin mountable to one of the first and second board subassemblies and a jack socket mountable to the other of the first and second board subassemblies.

In a further aspect, the abutment surfaces of first and second spacer supports are perpendicular to the stacking direction.

In a further aspect, the guide flanges of the first and second spacer supports laterally straddle the second board subassembly.

In a further aspect, the guide flanges of the first and second spacer supports are shorter than a board width of the second board subassembly in a traverse direction orthogonal to the lateral direction and the stacking direction.

In a further aspect, the board-to-board clamp comprises a first lever and a second lever each pivotally attached to the second board subassembly and each configured to engage a structural catch on each of the guide flanges.

In a further aspect, the step of actuating the first and second lever generates an insertion force in the stacking direction to assist mating the plurality of board-to-board connectors.

The disclosure also provides a board-to-board assembly comprising a first board subassembly comprising a first printed circuit board and a second board subassembly comprising a second printed circuit board parallel to and separated apart from each other in a stacking direction. Each of the first and second board subassemblies have a board width in a traverse direction perpendicular to the stacking direction. The board-to-board assembly further comprises a first spacer support and a second spacer support located between the first and second board subassemblies, each extending in the stacking direction. The first and second spacer supports are spaced apart from one another in a lateral direction perpendicular to the stacking direction and each of the first and second spacer supports comprises a support width less than the board width. The board-to-board assembly further comprise a board-to-board clamp forcibly securing the first and second board subassemblies to one another in the stacking direction.

A possible advantage of the disclosure is that it provides for simplified assembly of a board-to-board assembly having first and second board subassemblies arranged in a stacked or mezzanine arrangement. A related possible advantage is that the geometric configuration of the spacer supports and the associated guide flanges, and the related operation of the board-to-board clamp, reduces obstruction of the opposing and/or external faces of the board subassemblies. Another possible advantage is that configuration of the board-to-board connectors and the geometric design of the spacer supports cooperate to provide an assembly sequence that improves assembly including, for example, mating of the board-to-board connectors.

### BRIEF DESCRIPTION OF THE DRAWINGS

Figure 1 is a front perspective view of a computer system with a chassis or enclosure, partially removed, that is designed to accommodate internal computer components including a midplane configured as a board-board assembly that is located between a forward chassis end and a rearward chassis end.
Figure 2 is a rear perspective view of the computer system with the chassis partially removed to show the midplane located between the forward chassis end and the rearward chassis end.
Figure 3 is a perspective view of the board-to-board assembly including a first board subassembly secured in a parallel, stacked alignment with a second board subassembly.
Figure 4 is a perspective partially exploded view of the board-to-board assembly with the first board subassembly and the second board subassembly unsecured and separated with respect to a stacking direction.
Figure 5 is a further exploded view of the first and second board subassemblies each including a planar, rigid printed circuit board installable with a board frame and having first and second spacer supports extending the stacking direction.
Figure 6 is detailed perspective view of a spacer support having a guide flange extending from an abutment surface thereof in the stacking direction and which includes a structural catch protruding in a lateral direction.
Figure 7 is a detailed perspective view of a lever pivotally attached to one of the board frames and forming a component of a board-to-board clamp that engages the structural catch to secure the first and second board subassemblies into the stacked, parallel arrangement.
Figure 8 is an elevational view of the board-to-board assembly with the first and second board subassemblies positioned in parallel with each other and a plurality of board-to-board connectors positioned for mating together.
Figure 9 is an elevational view of the assembly sequence for producing the board-to-board assembly including moving the first and second board subassemblies together in the stacking direction and securing the board subassemblies by actuating the board-to-board clamp.
Figure 10 is a plane view of the second board subassembly stacked over the first board subassembly showing the spatially accommodative arrangement between the spacer supports and the board widths.

### DETAILED DESCRIPTION

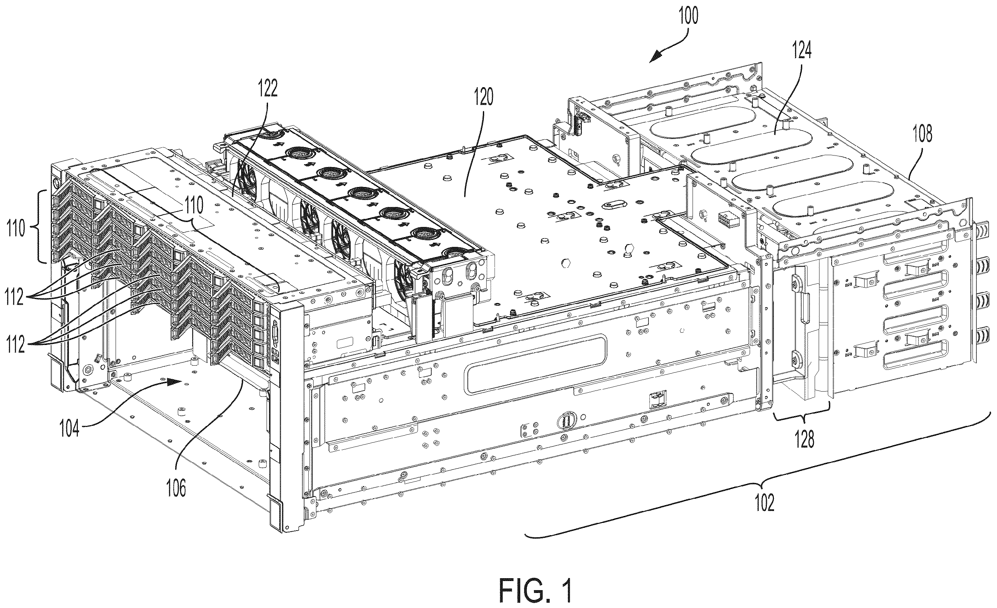

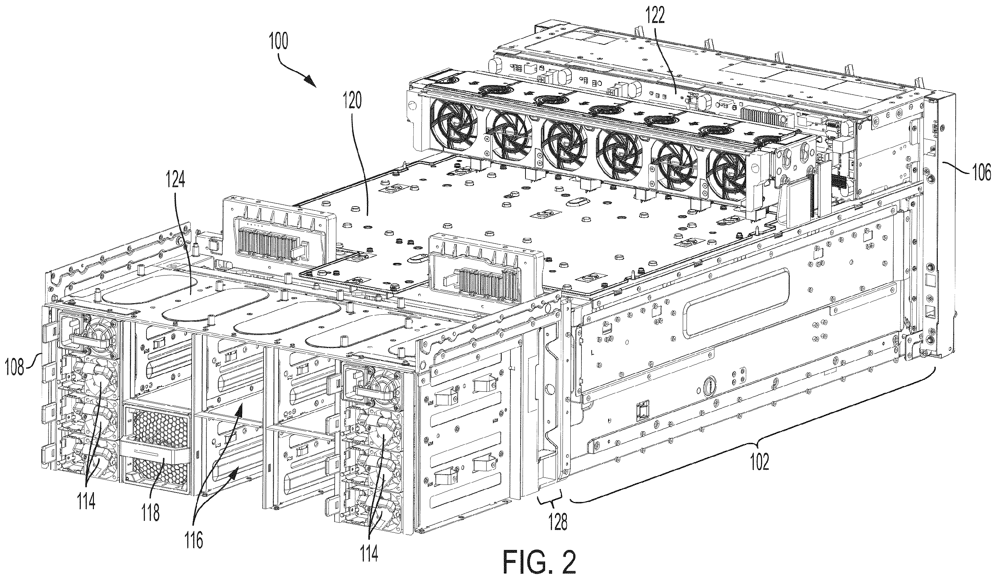

Now referring to the drawings, where whenever possible like reference numbers will refer to like elements, there is illustrated in FIGS. 1 and 2 a computer system 100 comprised of various electronic devices and hardware that are cooperatively interconnected and assembled together and that may be accommodated in a common computer case or enclosed chassis 102. The chassis 102 can be a box-like structure made of formed sheet metal or molded plastic that can be assembled to defines an internal space or chassis volume 104 for the internal computer components and electronic hardware of the computer system 100. The computer system 100 can be configured for communicative integration with a larger network or system and the chassis 102 may be designed for mounting into a rack with similar computer systems, although in other instances the computer system 100 may be a standalone configuration.

The chassis 102 can accommodate components and hardware devices like central processing units, memory modules, hard drives, power convertors, and fan units for circulating air internally about the chassis volume 104 for cooling of the internal components. The computer system 100 may be rectangular in shape and can extend between a front panel 106 and rear panel 108 that are parallel to each other and located opposite one another. The front and rear panels 106, 108 can include various LED indicator lights, activation and setting buttons and switches, ports and sockets for data and power communications, and other features for interfacing with operators and other systems.

For example, referring to FIG. 1, the computer system 100 may be configured as a server and the front panel 106 can define a plurality of expansion bays 110 or expansion slots that can receive individual expansion cards 112. In a specific example, the expansion card 112 can include one more graphics processing units (GPUs) that are designed for applications such as image processing, data analytics, artificial intelligence, and other high-performance computing applications. In the illustrated example, the expansion bays 110 and the expansion cards 112 accommodated therein can be oriented horizontally in a stacked arrangement with respect to the box-like chassis, but other orientations are possible.

Referring to FIG. 2, the rear panel 108 can accommodate a plurality of power supply units (PSUs) 114 that can interface with external power cables to receive electrical power. Each of the power supply units 114 may have a power socket to mate with a corresponding plug of the power cable, and may include internal components and devices for altering the characteristics and properties of the electrical power. In the example of a server, the computer system 100 can require a significant amount of power and therefore a plurality of power supply units 114 are included that may be aligned vertically toward the lateral sides of the chassis 102.

In addition, the rear panel 108 can include a plurality of fan bays 116 that are located between the laterally oriented power supply units 114. The fan bays 116 are designed to accommodate a fan unit 118 or fan module having a motor-driven fan impeller to circulate airflow with respect to the chassis volume 104. To improve airflow and thermal cooling, the enclosed chassis 102 is typically not airtight but may include vents and openings.

As described above, the computer system 100 can include several printed circuit boards (PCBs) having electronic devices mounted thereon arranged and interconnected to perform specific computational and logical functions. For example, accommodated in the chassis 104 can be a motherboard 120 onto which are mounted the major components of the computer system 100 including processors, main memory, BIOS, and support circuitry. An expansion board 122 having expansion sockets or slots can be located toward the front panel 106 of the chassis 102. The computer system 100 can also include a switch board 124 located toward the rear panel 108 configured to make external network data connections and to switch and route internal and external data signals.

To provide connectivity between the various boards and electrical components, the computer system 100 may also include a midplane 128 that is located approximately midway between the front and rear panels 106, 108 of the computer system 100. The midplane 128 can be made of one or more planar printed circuit boards (PCBs) that are oriented vertically upright in the chassis 102 so as to extend parallel with the planes defined by the front and rear panels 106, 108, although other orientations of the midplane are possible. The midplane 128 may also extend across the lateral width of the computer chassis 102. Due to the internally centralized location in the chassis volume 104, the midplane 128 is advantageously arranged to receive and direct data and power signals through the computer system 100. The midplane 128 provides for the convenient installation, interconnection, and substitution of different electrical devices to increase the functionality and capabilities of the computer system 100

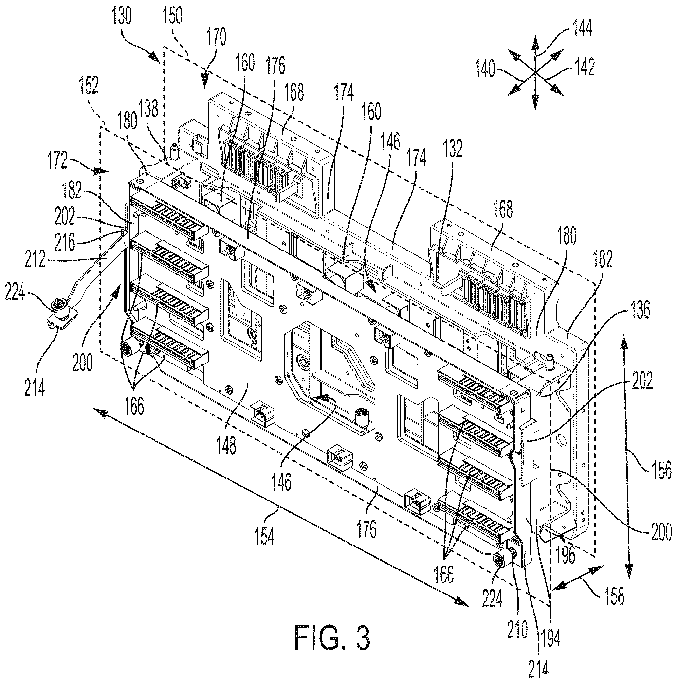

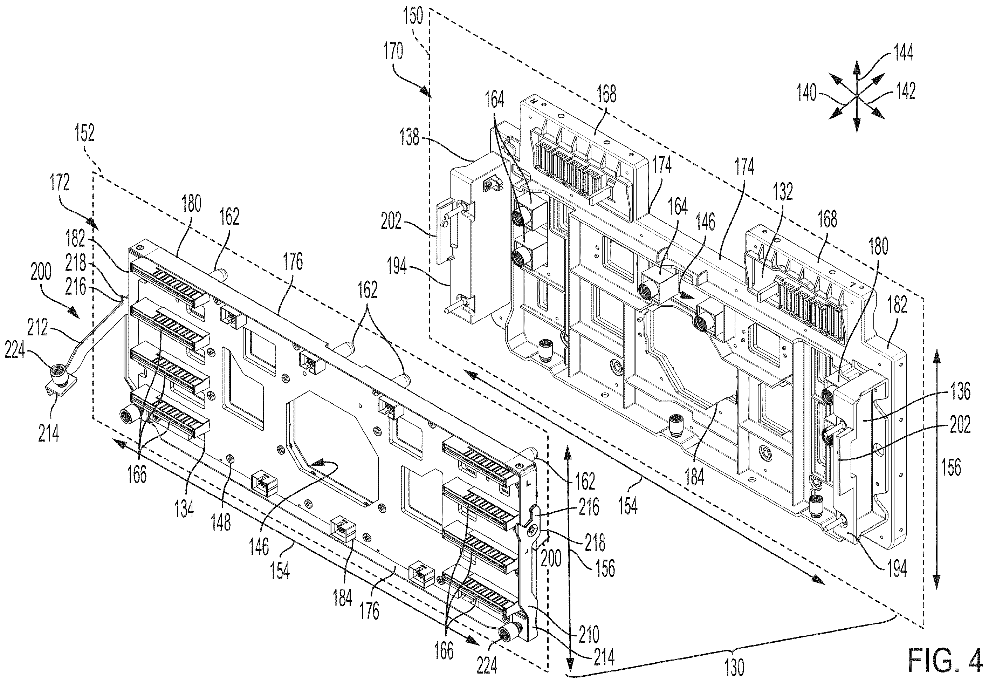

Referring to FIGS. 3 and 4, the midplane 128 can be comprised of a plurality of printed circuit boards (PCBs) to increase the usable area and spatially accommodate the quantity of electronic devices and connectors required by the computer system 100. For example, the computer system 100 is intended to function as a server providing resources and computing capabilities to a plurality of interconnected client systems via a communication network.

Accordingly, to increase the available space, the midplane 128 can be configured as a board-to-board assembly 130 including a first board 132 and a second board 134 that are oriented in a parallel, spaced relation, which may be referred to as a mezzanine arrangement or stacked arrangement. The mezzanine or stacked orientations of the board-to-board assembly 130 distinguishes other common board-to-board arrangements such as orthogonal in which two boards perpendicularly contact or intersect each other and a horizontal arrangement wherein two boards are arranged in a coplanar, side-by-side or butt ended configuration.

In the board-to-board assembly 130 of the midplane 128, the first board 132 and the second board 134 can each be printed circuit boards that are characteristically rigid and planar. The printed circuit boards for the first and second boards 132, 134 are typically constructed from a rigid, electrically non-conductive substrate made of an insulative material such as phenolic resin. A pattern of conductive traces can be disposed over the surface of the substrate. Electronic devices can be mounted to the surface of the substrate to make electrical contact with the conductive traces thereby establishing electronic communication between the other devices associated with the midplane 128 and/or remote devices and printed circuit boards. Any suitable surface mounting technique can be used to mount the electronic devices and/or connectors to the surfaces of the first and second boards. In various examples, the printed circuit boards comprising the first and second boards 132, 134 can be made of several suitable insulative substrates and patterned conductive traces laminated or adhered together to increase the capacity and thickness of the first and second boards 132, 134.

By way of example, the first board 132 can be designated the midplane board and may include on the planar surfaces thereof multiple electronic devices and electrical connectors to receive and redirect electronic data signals and electrical power within the computer system 100. The electrical connectors can have any suitable configuration or design for electrical communication including single or multiterminal connectors, pin headers and box headers, male and female plug and socket connectors, terminal blocks, and the like. The connectors can be configured to mate with conductive cables, wires, or corresponding connectors on other printed circuit boards. The connectors can be arranged in any suitable mating orientation including parallel, perpendicular, and horizontal.

To increase the density and functionality of the midplane 128, the second board 134 can be included in the board-to-board assembly 130. The second board 134 can be designated an auxiliary board and can be similarly configured and constructed to include surface mounted electrical connectors and devices to supplement the functionality of the midplane or first board 132. To separate and space apart the first and second boards 132, 134 in the parallel or mezzanine orientation, the board-to-board assembly 130 can include a first spacer support 136 and a second spacer support 138 that are spatially located between the first and second boards 132, 134. The first and second spacer supports 136, 138 can be integrally formed with companion structures as part of the board-to-board assembly 130 or may be distinct components.

The first and second spacer supports 136, 138 can be configured to space apart and separate the parallel first and second boards 132, 134 with respect to an assembly or stacking direction 140 or z-axis as indicated. The stacking direction 140 can be normal or orthogonal to the planar shapes associated with the first and second boards 132, 134 which are parallel to each other in the board-to-board assembly 130. For reference, the stacking direction 140 can be relationally associated with other coordinate directions including a lateral direction 142 and a traverse direction 144 that may be both perpendicular to the stacking direction and parallel with the planar orientations of the first and second boards 132, 134.

The parallel, spaced apart relation of the first and second boards 132, 134 with respect to the stacking direction 140 results in the flat, planar configuration of each board being associated with opposing faces 146 directed toward each other and with external faces 148 directed outwardly and away from each other with respect to the stacking direction 140. The opposing faces 146 and the external faces 148 are the opposite exterior surfaces of each of the planar first and second boards 132, 134. The parallel, spaced-apart orientations of the first and second boards 132, 134 may also define or be associated with board planes 150, 152 situated in the lateral and traverse directions 142, 144 and perpendicular to the stacking direction 140.

The first and second boards 132, 134 may, in an example, be generally rectangular in shape and can include a board length 154 that corresponds with the lateral direction 142 and a board width 156 that corresponds with the traverse direction 144. The rectangular shape can be associated with linear or curved edges of the planar first and second boards that extend in the lateral and/or traverse directions 142, 144. The first and second boards 132, 134 may also have other shapes and different numbers of linear or curved edges.

When the first and second boards 132, 134 are joined together in the board-to-board assembly 130, the first and second spacer supports 136, 138 maintain separation of the boards with respect to the stacking direction 140 resulting in stacking height 158 of the board-to-board assembly 130. The stacking height 158 may be associated with the spacing or gap separating the opposing faces 146 of the first and second boards 132, 134 providing airflow circulation therebetween.

To establish electrical communication between the first board 132 and the second board 134, which are parallel and separated in the stacking direction 140 when configured in the mezzanine board-to-board assembly 130, a plurality of board-to-board connectors 160 can be utilized. The board-to-board connectors 160 can be assembled of hardware components that are distributed between and surface mounted on first and second boards 132, 134 in a corresponding pattern. The board-to-board connectors 160 are designed to mate together and establish an electrical connection when the first and second boards 132, 134 are moved together in the stacking direction 140.

An example of the board-to-board connector 160 can be a jack style connector configured to establish a single electrical connection or communication line when mated. The jack-style board-to-board connector 160 can include a conductive prong pin 162 or terminal that protrudes normally from the planar opposing face 146 of the second board 134, for example, than can be received in a corresponding jack or socket 164 mounted to the opposing face 146 of the first board 132. The jack socket 164 includes an internal conductive structure in an insulative housing, made of plastic for example, and that is accessible by an opening into which the cylindrical prong pin 162 can be received.

The jack style board-to-board connectors 160 can be conductive of substantial currents and voltages associated with the transmission of electrical power. An example of a jack style board-to-board connectors 160 can be a RADSOK^{®} connector available from Amphenol. The plurality of board-to-board connector 160 can be spread about and distributed over the planar opposing surfaces 146 of the first and second boards 132, 134 to distribute the contact and mating forces when the first and second boards 132, 134 are moved together in the stacking direction 140. For example, the board-to-board connector 160 may be located toward the peripheral edges of the first and second boards for visibility during alignment and mating.

To correctly align and position the first and second board 132, 134 with respect to each other, the board-to-board connectors 160 can be arranged in a complementary alignment pattern. For example, because the components of the board-to-board connectors 160 are distributed on the opposing faces 146 of both the first and second boards 132, 134, when mated, the board-to-board connectors 160 cause the boards to move and assume desired spatial positions in the lateral and traverse directions 142, 144 with respect to each other. The alignment pattern may result in alignment of the second board 134 between the first and second spacer supports 136, 138 in the lateral direction 140.

In addition to board-to-board connectors 160, the board-to-board assembly 130 can include a plurality of external connectors 166 that are configured to establish electrically communicative connections between the board-to-board assembly 130 and other electrical components and computing devices. For example, the external connectors 166 can be designed as a pin header type in which a female socket includes a plurality of conductive contacts disposed inline in an insulative housing that may be surface mounted to the external face 148 of the first and/or second boards 132, 134. The pin socket can mate with a pin header having a plurality of conductive pins to concurrently establish a plurality of electrical contacts. The pin header may be attached to a ribbon cable or the like. As another example, the external connectors 166 can be configured as edge connectors each defining a linear, elongated slot that can receive the edges of another printed circuit board having exposed electrical traces thereon.

To further assist in connecting the midplane 128 with additional boards and devices, the board-to-board assembly 130 can include one or more board tabs 168 that project from the envelope or profile of the assembly for accessibility. For example, the board tabs 168 can be extensions of the first board 132 that extend from the lengthwise edge in the traverse direction 144. Accordingly, when the first and second boards 132, 134 are assembled, the board tabs 168 are exposed beyond the rectangular profile or outline of the board-to-board assembly 130 for unobstructed accessibility. The board tabs 168 can have external connectors mounted thereon.

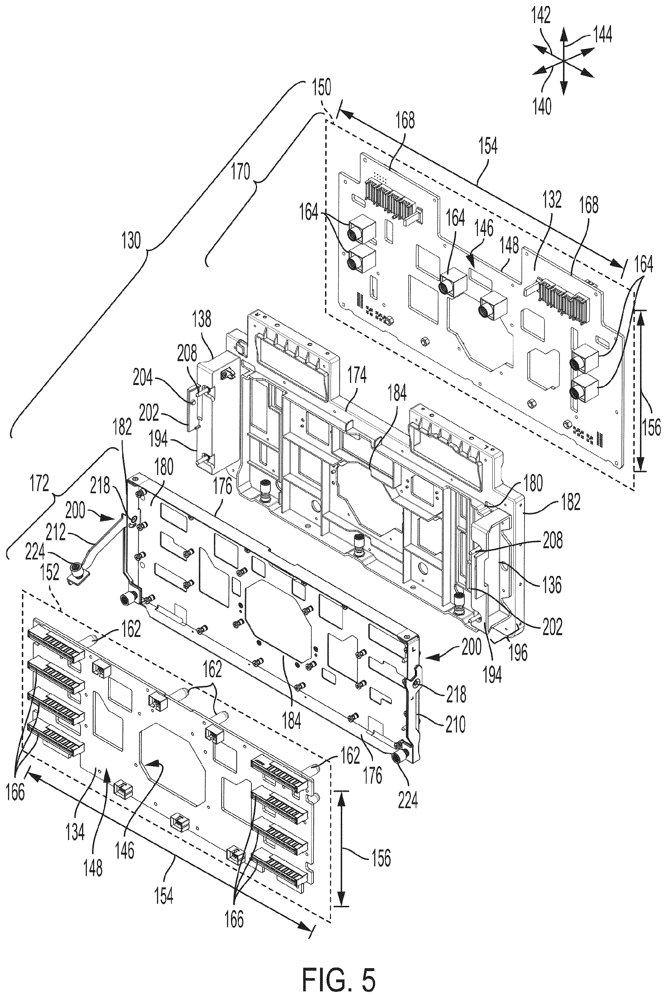

Referring to FIG. 5, to facilitate connection and stacking together of the board-to-board assembly 130, the first and second boards 132, 134 and the components thereon can be operatively associated with a first board subassembly 170 and a second board subassembly 172 respectively. For example, to produce the first board subassembly 170, the first board 132 may be installed in a first board frame 174 and to produce the second board subassembly 172, the second board 134 may be installed in a respective second board frame 176. The first and second board frames 174, 176 can be configured to generally correspond with the outline and planar shape of the first and second boards 132, 134 respectively. The board frames 174, 176 outline and bracket the first and second boards 132, 134 to add rigidity while at least partly exposing the opposing face 146 and the external face 148 for accessibility.

For example, each of the first and second board frames 174, 176 can include a planar plate 180 that extends to an upturned edge or peripheral rim 182 normal to the planar plate 180 and aligned in the stacking direction 140. The planar plate 180 and upturned peripheral rim 182 correspond in rectangular shape with the first and second boards 132, 134 and can define a space or cavity to receive the first and second boards therein. When installed, the planar plate 180 can extend adjacently against the opposed faces 146 of the respective first and second boards 132, 134 and the peripheral rims 182 can extend adjacently along edges of the rectangular boards in the lateral and traverse directions 142, 144.

The first and second boards 132, 134 can be installed to the first and second board frames 174, 176 by a snap fit arrangement, for example, between the upturned peripheral rim 182 and the edges of the boards, or can be attached by fasteners. The planar plates 180 of the first and second board frames 174, 176 can include frame apertures 184 to enable pass through connections between the board-to-board connectors and to correspond with the board apertures for circulation and visibility. The first and second board frames 174, 176 can be manufactured from a rigid material such as zinc alloy or a nonconductive insulator material such as molded plastic.

To facilitate assembly of the parallel board-to-board assembly, the first and second spacer supports 136, 138 can be joined to one of the first and second board frames 174, 176 to construct an integrated structure. For example, the first and second spacer supports 136, 138 can be permanently fixed to the first board frame 174 by fasteners, for example, and can project from the planar plate 180 so as to extend in the stacking direction 140. In another example, the first and second spacer supports 136, 138 can be integrally formed with the first board frame 174, by molding for example, to produce a monolithic structure. The spacer supports and the board frames can be made of the same material, for example, zinc alloy or molded plastic.

The first and second spacer supports 136, 138 associated with the first board frame 174 can project from the planar plate 180 to extend in the stacking direction 140. The first and second spacer supports 136, 138 can be spaced apart with respect to the lateral direction 142 to be associated with the lateral edges of the first and second board 132, 134. The first and second spacer supports 136, 138 may be laterally separated at the opposite ends of the board length 154 although the spacer supports 136, 138 may also be located closer together with to respect the lateral direction 142.

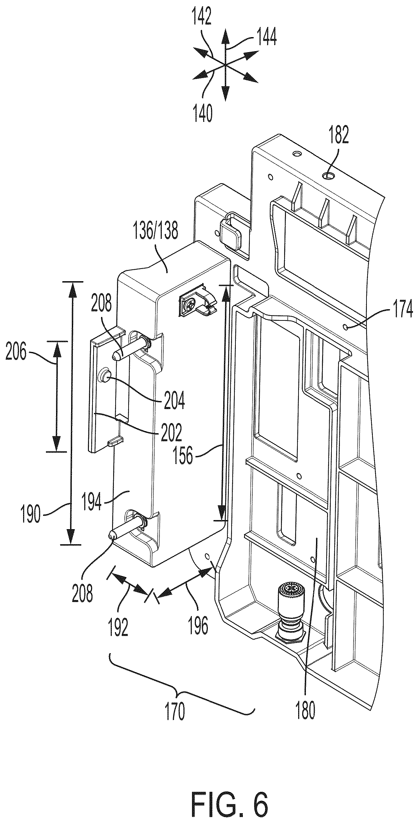

Referring to Figure 6, the first and second spacer supports 136, 138 can be structurally configured to enable an abutting connection with the opposing board subassembly while maintaining separation with respect to stacking direction 140. For example, the first and second spacer supports 136, 138 can each be geometrically shaped a polyhedron and, in an example, a cubic rectangle. In an example, the cubic rectangular shape of the first and second supports spacers 136, 138 can define a support width 190, which corresponds to the traverse direction 144, and a support thickness 192 that corresponds to the lateral direction 142. The dimension of the support width 190 in the traverse direction 144 may be comparatively less than the corresponding board widths 156 of the first and second boards 132, 134 indicated in FIGS. 3-4. The support widths 190 of the first and second spacer supports 136, 138 are therefore shorter in the traverse direction 144 than the corresponding width of the first and second board subassemblies 170, 172 associated with the first and second boards 132, 134.

The spacer supports 136, 138 can extend from the planar plate 180 of the first board frame 174 in the stacking direction 140 and can terminate in a flat abutment surface 194 that extends parallel to the planar plate 180. The outline of the flat abutment surface 194 can be rectangular in correspondence with the cubic rectangular shape of the first and second spacer supports 136, 138. The distance between the planar plate 180 and the abutment surface 194 defines a support height 196 which corresponds to the separation in the stacking direction 140 between the first and second boards 132, 134 in the board-to-board assembly 130.

To position and stack the first and second board subassemblies 170, 172 together during assembly of the board-to-board assembly 130, the first and second spacer supports 136, 138 can be operatively associated with a board-to-board clamp 200. The board-to-board clamp 200 can include distinct structural components that cooperate to hold the first and second board subassemblies 170, 172 in a fixed relation compressed together along the stacking direction 140. The board-to-board clamp 200 can also function to align the opposing faces 146 of the first and second boards 132, 134 with each other in the lateral and traverse directions 142, 144.

For example, to facilitate aligning and positioning the first board subassembly 170 with the second board subassembly 172, the first and second spacer supports 136, 138 can include a respective guide flange 202 that projects and extends from the abutment surface 194 in the stacking direction 140. The guide flange 202 can be integrally formed and structurally joined with the first and second spacer supports 136, 138 and can be made of the same material. The guide flanges 202 can be elongated, linear structures that are aligned in the traverse direction 144 and perpendicular to the lateral direction 142.

The guide flanges 202 can be geometrically rectangular in shape and can be situated proximately to the laterally outer exteriors of the first and second spacer supports 136, 138. The guide flanges 202 of the laterally opposed first and second spacer supports 136, 138 therefore defines a lateral gap or distance in the lateral direction 142 that can receive the lengthwise extension of the second board subassembly 172. Accordingly, the distance in the lateral direction between the guide flanges 202 can be commensurate with the board length 154 of the second board 134 as installed in the second board frame 176.

The guide flanges 202 can also have a flange width 206 in the traverse direction 144 that is shorter than the support width 190 of the spacer supports 134, 136. The flange widths 206 are subsumed with respect to the support widths 190. In a further embodiment, to facilitate alignment of the second board subassembly with respect to the first and second spacer supports 134, 136, one or more guide pins 208 can project from the abutment surfaces 194 in the stacking direction to be received in corresponding pin apertures in the second board frame 176.

Referring again to FIG. 6, to interact with a corresponding structure on the second board subassembly, the board-to-board clamp 200 can include a structural catch 204 that is located on the guide flange 202. The structural catch 204 can be configured as a rounded peg or boss that protrudes in the lateral direction 142 from an interior flat face of the guide flanges 202. The structural catch 204 may be cylindrical in shape with a relative small diameter and may be spaced apart in the stacking direction 140 from the flat abutment 194 and extends parallel in the lateral direction 142 to the flat abutment surface 194 of the respective first and second spacer supports 136, 138.

Referring back to FIGS. 3 and 4, the board-to-board clamp 200 can also include a first lever 210 and a second lever 212 that are pivotally attached to the second board frame 176 of the second board subassembly 172. To correspond locationally with the first and second spacer supports 136, 138, the first and second levers 210, 212 can be pivotally attached at the laterally opposite ends of the second support frame 176 and spaced apart from each other with respect to the lateral direction 142. The first and second levers 210, 212 can be generally aligned in the lateral direction and may correspond with the board width 156 associated with the second board 134 installed in the second board subassembly 172.

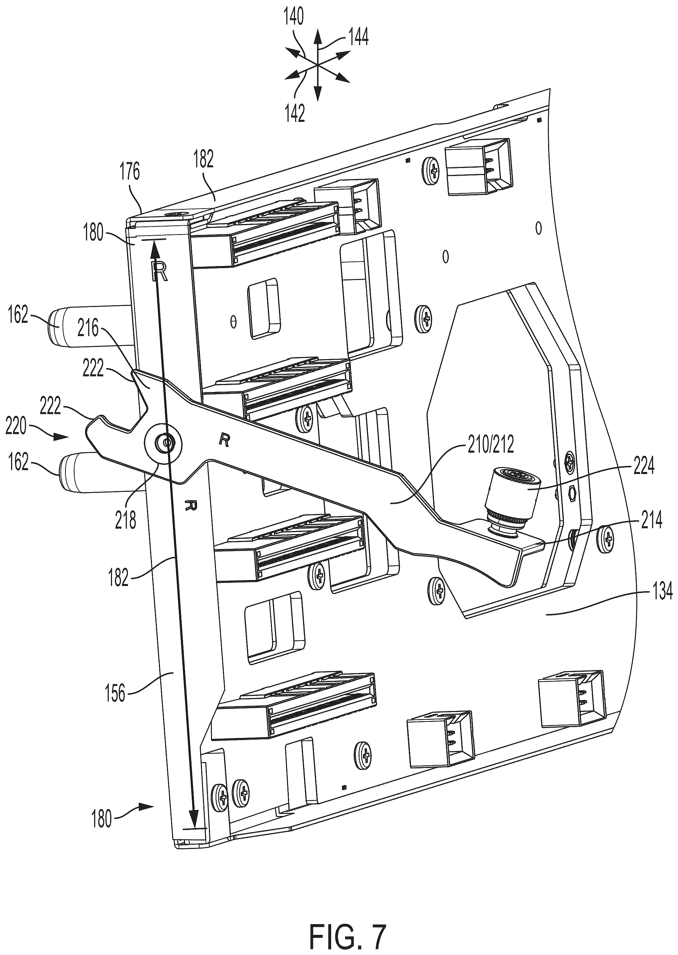

Referring to FIG. 7, the first and second levers 210, 212 can be pivotally attached to the upturned peripheral rim 182 of the second support frame 176 extending in the stacking direction 140. The first and second levers 210, 212 can be linear elongated structures extending between a free handle 214 and an oppositely located clamping structure 216. The first and second levers 210, 212 can be pivotally connected to the upturned peripheral rim 182 of the second board frame 176 at a pivot point or fulcrum 218 that is situated between the free handle 214 and the clasping structure 216. The fulcrum 218 can be a pivot joint or revolute joint structurally embodied as a rivet or pin. The comparative dimensions of the free handle 214 and the clasping structure 216 with respect to the fulcrum 218 creates leverage and can apply mechanical advantage when the first and second levers 210, 212 are pivoted.

To catch and engage the structural catch 204 on the lateral flange 202, the clasp structure 216 can be configured as a bifurcated jaw 220 having spaced apart prongs 222 defining a gap there between. The gap dimension between the prongs 222 of the bifurcated jaw 220 corresponds with the diameter of the boss structure functioning as the structural catch 204 protruding from the lateral flanges 202. The clasp structure 216 shaped as a bifurcated jaw 220 is able to receive and rotationally slide about the structural catch 204.

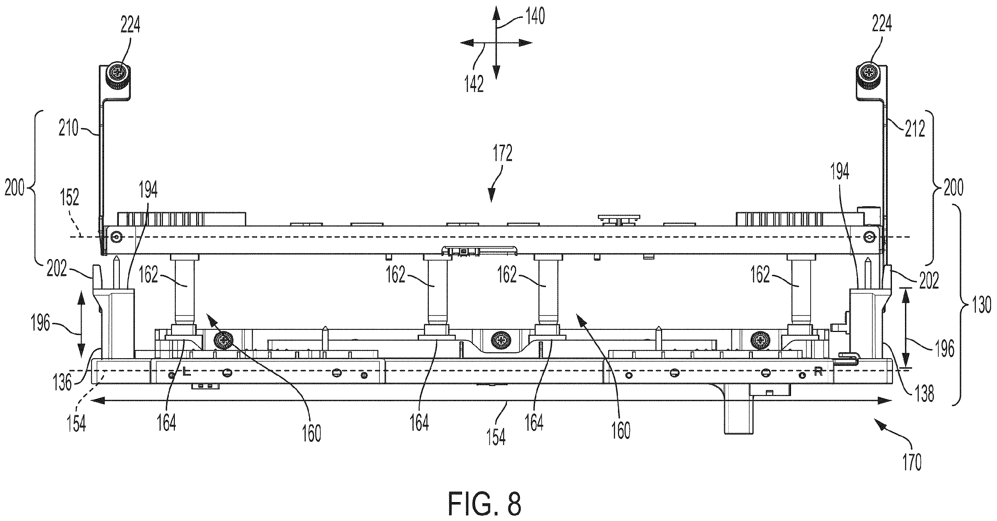

Referring to FIG. 8, to assemble the board-to-board assembly 130, the first board subassembly 170 and the second board subassembly 172 are oriented parallel to each other and separated in the stacking direction 140. To align the components of the board-to-board clamp 200 while the first and second board subassemblies 170, 172 are moved together in the lateral direction 140, the mating board-to-board connectors 160 associated with the first and second boards 132, 134 can be connectively mated. For example, as the prong pins 162 are received in the corresponding jack sockets 164, the mating board-to-board connectors 160 will align the parallel orientations of the first and second board subassemblies 170, 172.

For example, due to the distinctive arrangement of the mating board-to-board connectors 160, the second board subassembly 172 is laterally positioned with respect to the first and second spacer supports 136, 138. In particular, as the components of the board-to-board connectors 160 mounted to the opposing faces 146 of the first and second boards 132, 134 in the alignment pattern mate, they can concurrently position the second board subassembly 172 between the guide flanges 202.

To cause the mating board-to-board connectors 160 to position the first and second board subassemblies 170, 172 into alignment before abutting the abutment surface 194 of the first and second spacer supports 136, 138, the prong pins 162 and jack socket 164 can have a mating height in the stacking direction that is greater than the support height 196. Insertion of the prong pins 162 into the jack sockets 164 is initiated before contact occurs between the opposing face 164 of the second board 134 and/or the planar plate 180 of the second broad frame 176 contact the abutment surface 194.

Furthermore, due to the comparative board lengths 154 in the lateral direction 142, the second board subassembly 172 is laterally positioned between the opposed guide flanges 202 extending from the first and second spacer supports 136, 138. For example, that may be spaced apart a greater distance in the lateral direction than the board length 154. Accordingly, the guide flanges 202 laterally straddle the second board subassembly 172 and the components of the board-to-board clamp 200 are aligned for cooperative engagement.

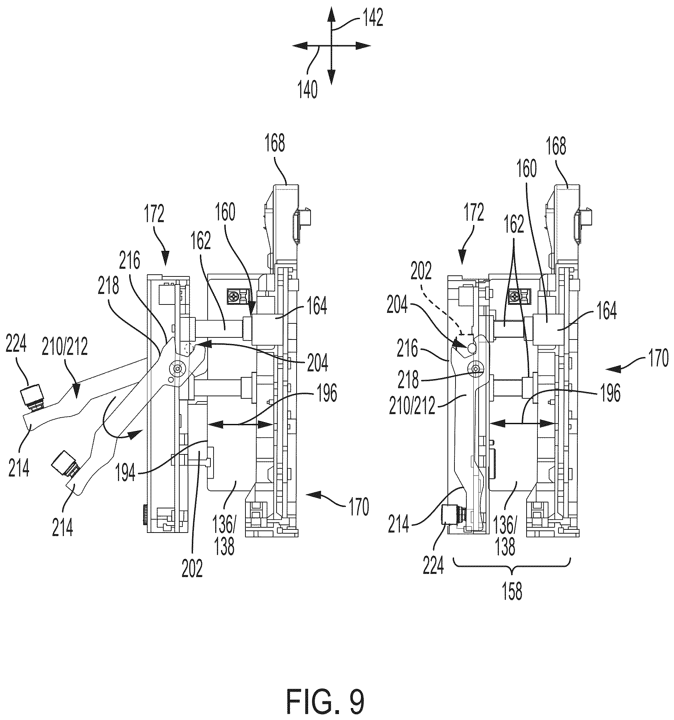

For example, referring to FIG. 9, the alignment of the mating board-to-board connectors 160 may align the bifurcated jaw of the board-to-board clamp 200 on the pivoting levers 210, 212 in proximity to receive the structural catch 204 protruding from the guide flange 202. When the first and second levers 210, 212 are pivoted with respect to the second board subassembly 172, the mechanical advantage and leverage produced by engagement between the clasp structure 216 and the structural catch 204 forcibly moves the second board subassembly 172 toward the first board subassembly 170 in the stacking direction 140.

Movement of the first and second board subassemblies 170, 172 together in the stacking direction 140 moves the planar plate 180 of the second board frame 176 into abutting contact with the abutment surfaces 194 extending along the first and second spacer supports 136, 138. The first and second boards 132, 134 installed in the respective first and second board subassemblies 170, 172 are fixed in a parallel, spaced part orientation completing the board-to-board assembly 130. The support heights 196 associated with first and second spacer supports 136, 138 functions to maintain the spacing between the opposing surfaces 146 of the first and second boards 132, 134 enabling circulation and thermal cooling.

The mechanical advantage generated by the pivoting first and second levers 210, 212 and the resulting movement together of the parallel first and second board subassemblies 170, 172 in the stacking direction 140 also results in forcibly continuing the installation and mating of the board-to-board connectors 160. For example, pivoting of the first and second levers 210, 212 assists in overcoming the frictional insertion resistance of the jack socket 162 with respect to the prong pins 164.

To securely lock the first and second board subassemblies 170, 172 together in the parallel or mezzanine orientation of the board-to-board assembly 130, the first and second levers 210, 212 can each include a thumb screw 224 located at the distal ends of the free handle 214. When the first and second levers 210, 212 have been pivoted into parallel alignment with the traverse direction 144, the thumb screws 224 can be fastener with a corresponding threaded aperture or hole located on the planar plate 180 of the second board frame 172. The structural catch 204 is securely retained between the bifurcated jaw prongs of the clasp structure 216 and the first and second board subassemblies 170, 172 are prevented from separating in the stacking direction 140.

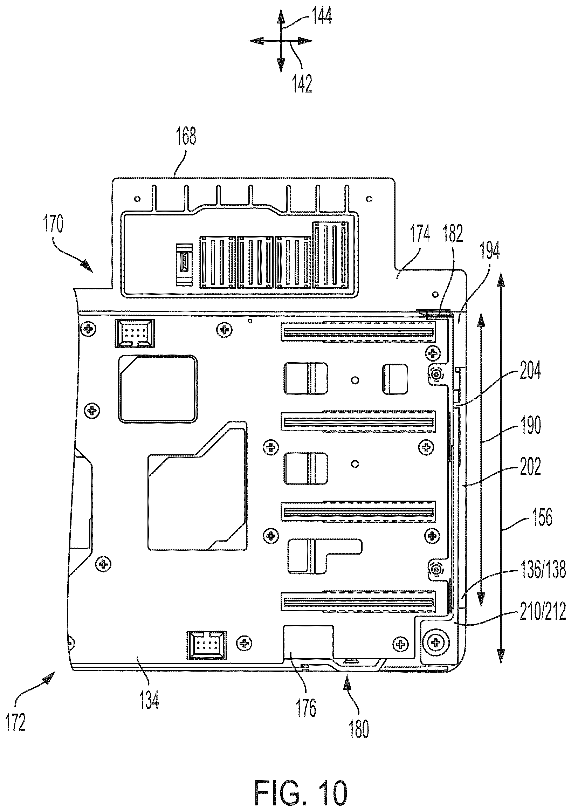

Referring to FIGS. 9 and 10, when stacked together in the stacking direction, the planar plate 180 of the second board frame 176 abuts against and extends substantially over the abutment surfaces 194 of the first and/or second spacer supports 136, 138. The support height 196 of the first and second spacer supports 136, 138 maintains separation between the first and second board subassemblies in the stacking direction 140 and establishes the stacking height 158. Moreover, because the board width 156 is larger than the support width 190 in the traverse direction 144, the second board subassembly 172 can substantially overlap the abutting surface 194 of the first and second spacer supports 136, 138. Only the traversely shorter guide flanges 202 that laterally straddle the second board subassembly 172 extend in the stacking direction 140 adjacent to the second board frame 176.

The lateral and traverse edges of the second board subassembly 172 and the second board 134 installed therein are accordingly not obstructed by the first and second spacer supports 136, 138. Nor does the second board 134 or the second board frame 176 require notches or the like to spatially accommodate the first and second spacer supports 136, 138, as may have occurred in conventional designs. More surface area of the opposing faces 146 of the second board 134 is therefore available for installing active components and cabling.

The use of the terms "a" and "an" and "the" and "at least one" and similar referents in the context of describing the invention (especially in the context of the following claims) are to be construed to cover both the singular and the plural, unless otherwise indicated herein or clearly contradicted by context. The use of the term "at least one" followed by a list of one or more items (for example, "at least one of A and B") is to be construed to mean one item selected from the listed items (A or B) or any combination of two or more of the listed items (A and B), unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A board-to-board assembly comprising:
a first board subassembly comprising a first printed circuit board in a planar orientation;
a second board subassembly comprising a second printed circuit board in a planar orientation parallel to the first print circuit board and spaced apart therefrom in a stacking direction;
a first spacer support and a second spacer support located between the first and second board subassemblies and each extending in the stacking direction, the first and second spacer supports spaced apart from one another in a lateral direction perpendicular to the stacking direction, the first and second spacer supports each comprising a guide flange extending adjacent to and laterally straddling the second board subassembly; and
a board-to-board clamp configured for forcibly securing the first and second board subassemblies to one another in the stacking direction.

2. The board-to-board assembly of claim 1, further comprising a plurality of board-to-board connectors associated with the first and second board subassemblies and arranged in a complementary alignment pattern to align the second board subassembly laterally between the guide flanges of the first and second spacer supports when mated.

3. The board-to-board assembly of claim 2, wherein the first and second spacer supports each has a support height and each of the plurality of board-to-board connectors has a mating height that is larger than the support height.

4. The board-to-board assembly of claim 3, wherein each of the plurality of board-to-board connectors comprises a prong pin mountable to one of the first and second board subassemblies and a jack socket mountable to the other of the first and second board subassemblies.

5. The board-to-board assembly of claim 1, wherein the first and second spacer supports each has a support width and each of the first and second board subassemblies has a board width that is larger than the support width.

6. The board-to-board assembly of claim 5, wherein the first and second spacer supports each has an abutment surface, perpendicular to the stacking direction, on which an opposing face of one of the first and second board subassemblies abuts.

7. The board-to-board assembly of claim 6, where in the guide flange of each of the first and second spacer supports extending perpendicularly from the abutment surface thereof.

8. The board-to-board assembly of claim 1, wherein the board-to-board clamp comprises a first lever and a second lever each adapted to engage a structural catch on the guide flange on each of the respective first and second spacer supports.

9. The board-to-board assembly of claim 8, wherein each of the first and second levers are pivotally attached to one of the first and second board subassemblies.

10. The board-to-board assembly of claim 9, wherein each of the structural catches on the guide flange of each of the first and second lateral supports protrudes in the lateral direction.

11. The board-to-board assembly of claim 10, wherein the first and second board subassemblies each comprises a first board frame and a second board frame into which the first printed circuit board and the second printed circuit board are respectively installed.

12. A method of assembling a board-to-board assembly comprising:
positioning a first board subassembly and a second board subassembly parallel with one another and separated from one another in a stacking direction, the first board subassembly comprising first and second spacer supports extending in the stacking direction and spaced apart from one another in a lateral direction orthogonal to the stacking direction;
mating a plurality of board-to-board connectors by moving the first and second board subassemblies toward one another in the stacking direction, the plurality of matting connectors arranged in a complementary alignment pattern to align the second board subassembly between guide flanges from each of the first and second spacer supports in the stacking direction;
guiding clamp components of a board-to-board clamp associated with the first and second board subassemblies into set proximity by continued moving the first and second board subassemblies toward one another in the stacking direction; and
actuating the board-to-board clamp to forcibly move the second board subassembly in the stacking direction to abut abutment surfaces on the first and second spacer supports extending for the first board subassembly.

13. The method of claim 12, wherein the abutment surfaces of first and second spacer supports are perpendicular to the stacking direction and laterally straddle the second board subassembly.

14. The method of claim 13, wherein the guide flanges of the first and second spacer supports are shorter than a board width of the second board subassembly in a traverse direction orthogonal to the lateral direction and the stacking direction.

15. The method of claim 12, wherein the board-to-board clamp comprises a first lever and a second lever each pivotally attached to the second board subassembly and each configured to engage a structural catch on each of the guide flanges to generate an insertion force in the stacking direction to assist mating the plurality of board-to-board connectors.
